## Europäisches Patentamt
## European Patent Office
## Office européen des brevets

(19)

(11) Numéro de publication: **0 245 147**
**A1**

(12) # DEMANDE DE BREVET EUROPEEN

(21) Numéro de dépôt: **87400932.7**

(22) Date de dépôt: **22.04.87**

(51) Int. Cl.4: **H 01 L 27/14**
**G 01 T 1/00**

(30) Priorité: **30.04.86 FR 8606334**

(43) Date de publication de la demande:
**11.11.87 Bulletin 87/46**

(84) Etats contractants désignés: **DE GB NL**

(71) Demandeur: **THOMSON-CSF**
**173, Boulevard Haussmann**
**F-75379 Paris Cédex 08 (FR)**

(72) Inventeur: **Berger, Jean-Luc**
**THOMSON-CSF SCPI 19, avenue de Messine**
**F-75008 Paris (FR)**

**Arques, Marc**
**THOMSON-CSF SCPI 19, avenue de Messine**
**F-75008 Paris (FR)**

(74) Mandataire: **Turlèque, Clotilde**
**THOMSON-CSF SCPI 19, avenue de Messine**
**F-75008 Paris (FR)**

(54) **Panneau de prise de vue radiologique, et procédé de fabrication.**

(57) La présente invention concerne un panneau de prise de vue radiologique, de grandes dimensions.

Ce panneau est constitué de plusieurs modules (4), mis bout à bout. Chaque module comporte un réseau de détecteurs photosensibles (d) ayant le même nombre de colonnes ($C_1$ à $C_n$) que le panneau mais ayant un nombre inférieur de lignes ($L_1$ à $L_m$). Chaque module (4) a ses propres moyens d'adressage (4) et de lecture (3). Les moyens d'adressage (2) sont situés sur un bord du substrat isolant (5) portant les détecteurs. Les moyens de lecture (3) sont situés de l'autre côté du substrat (5), par rapport aux détecteurs. Un écran (6), opaque au rayonnement à détecter, est intercalé entre le substrat (5) et ces moyens (3). Ces moyens (3) sont reliés aux connexions de colonnes ($C_1$ à $C_n$) provenant du côté opposé du substrat (5) par des connexions suivant l'une des faces latérales du substrat (5).

FIG_2

FIG_3

EP 0 245 147 A1

**Description**

PANNEAU DE PRISE DE VUE RADIOLOGIQUE ET PROCEDE DE FABRICATION

La présente invention concerne un panneau de prise de vue radiologique, de grande dimensions. Elle concerne également un procédé de fabrication de tels panneaux.

Pour la détection des rayons X, que ce soit en radiologie médicale ou industrielle, on est souvent amené à utiliser des panneaux de grandes dimensions, par exemple des panneaux carrés de 40 cm de côté.

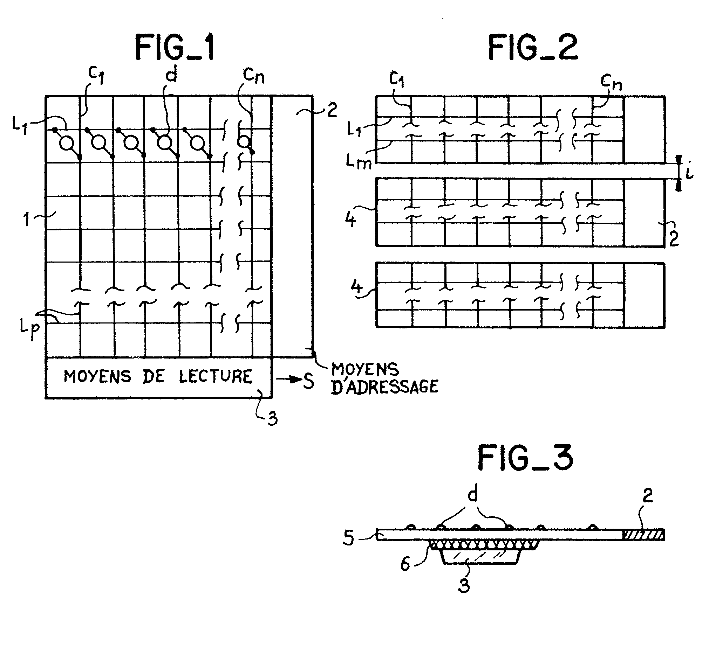

On a représenté sur la figure 1, de façon schématique, la structure de base d'un tel panneau. Ce panneau comporte un réseau 1 de détecteurs photosensibles d, disposés selon des lignes et des colonnes et reliés entre eux par des connexions de lignes $L_1$ à $L_p$ et par des connexions de colonnes $C_1$ à $C_n$. Sur la figure 1, on n'a représenté, pour des raisons de clarté, qu'une seule ligne de détecteurs d. Chaque détecteur est relié à une connexion de ligne et à une connexion de colonne.

Un écran scintillateur, non représenté, est intercalé entre le rayonnement X à détecter et le réseau de détecteurs.

Des moyens 2 reliés aux connexions de lignes, permettent l'adressage, successivement, de chaque ligne d'éléments photosensibles. Des moyens 3, reliés aux connexions de colonnes, permettent la lecture de la ligne d'éléments photosensibles qui a été adressée et fournissent le signal de sortie S du panneau.

Les éléments photosensibles d peuvent présenter diverses structures. La demande de brevet français n° 86.00716, déposée le 20 janvier 1986, au nom de THOMSON-CSF, décrit des réseaux d'éléments photosensibles pouvant être utilisés en radiologie, et constitués par l'association d'une photodiode et d'une capacité. L'intérêt de ces éléments est qu'ils ne comportent pas d'élément de commutation. Dans ce cas, on utilise, pour la lecture, un signal sous forme d'impulsions pour commander la décharge de la capacité associée à la photodiode. Ce type de structure permet de réaliser des matrices de grandes dimensions, du fait que les dépôts en couche mince, de silicium amorphe par exemple, sont maintenant bien maîtrisés. On sera amené dans la suite de la description à revenir sur cette demande de brevet précédemment citée.

Du fait de leurs grandes dimensions, les panneaux de prise de vue radiologique posent divers problèmes :

- chaque connexion de colonne est reliée à un grand nombre d'élément photosensibles, de l'ordre de 2000 par exemple. Or chaque élément photosensible introduit sur sa connexion de colonne une capacité non négligeable. En conséquence, le temps de lecture et le bruit sont augmentés ;

- les courants d'obscurité de tous les éléments photosensibles reliés à une même connexion de colonne sont additionnés, en particulier pendant la lecture des détecteurs, ce qui introduit un signal parasite dépendant de la température et générateur de bruit ;

- enfin, la difficulté de réalisation technologique pour obtenir un panneau de prise de vue radiologique, sans défaut, augmente très rapidement avec la surface du panneau.

La présente invention propose une solution à ces divers problèmes.

Le panneau de prise de vue radiologique selon l'invention est caractérisé en ce qu'il est constitué de plusieurs modules, mis bout à bout, chaque module comportant un réseau de détecteurs photosensibles ayant le même nombre de colonnes que le panneau, mais ayant un nombre inférieur de lignes, et chaque module ayant ses propres moyens d'adressage et de lecture, les moyens d'adressage étant situés sur un bord du substrat isolant qui porte les détecteurs photosensibles, côté détecteurs photosensibles, et protégés du rayonnement à détecter par un écran, les moyens de lecture étant situés de l'autre côté du substrat par rapport aux détecteurs photosensibles, un écran opaque au rayonnement à détecter étant intercalé entre le substrat et ces moyens, et ces moyens étant reliés aux connexions de colonnes provenant du côté opposé du substrat par des connexions suivant l'une des faces latérales du substrat.

La présente invention concerne également un procédé de fabrication d'un mode de réalisation particulier de l'invention dans lequel les connexions de colonne sont des connexions déposées sur une face du substrat isolant, côté détecteurs, puis sont des connexions déposées sur un support isolant souple qui est collé sur une face latérale du substrat isolant et relié aux moyens de lecture. Ce procédé comporte les étapes suivantes :

- 1°) on colle sur l'une des faces latérales du substrat isolant un support isolant souple portant des conducteurs ;

- 2°) on rode ce support pour que les extrémités des connexions qu'il porte soient situées dans le même plan que la face du substrat, côté détecteurs ;

- 3°) on dépose sur la face du substrat, côté détecteurs, les connexions de colonnes de telle sorte qu'à l'extrémité du substrat les connexions déposées chevauchent les connexions portées par le support isolant souple ;

- 4°) on relie les connexions portées par le support isolant souple aux moyens de lecture par soudure.

L'invention permet de résoudre les problèmes posés par les panneaux de prise de vue radiologique selon l'art antérieur, comme cela va être expliqué ci-après.

Le nombre d'éléments photosensibles reliés à chaque connexion de colonne étant plus faible dans les panneaux selon l'invention, le bruit est diminué, et éventuellement le temps de lecture. Comme chaque module constituant le panneau peut être lu, séparément, et rapidement, du fait de son petit nombre de lignes, deux modes de lecture peuvent être adoptés. Dans ces deux modes de lecture, on choisit généralement de lire simultanément tous les modules. Une mémoire-tampon recueille les signaux de sortie de ces modules pour permettre la reconstitution de l'image complète.

Dans un premier mode de lecture, on conserve le même temps de lecture de la totalité du panneau selon l'invention que dans le cas d'un panneau d'une seule pièce selon l'art antérieur. On dispose alors d'un temps plus important pour lire chaque ligne de détecteurs. Cela permet d'utiliser des moyens d'adressage fonctionnant à fréquence plus basse. On a donc un choix plus large de composants pouvant réaliser ces moyens. On peut par exemple utiliser des composants en silicium amorphe, dont la mobilité est très faible par rapport à celle des composants en silicium cristallin, mais qui peuvent être plus facilement réalisés sur de grandes surfaces. Dans la demande de brevet no 86.00716, les détecteurs photosensibles sont lus par des amplificateurs opérationnels intégrateurs et l'on effectue un multiplexage des connexions de colonne afin que les amplificateurs intégrateurs fonctionnent dans des conditions satisfaisantes, sans en multiplier trop le nombre. Comme l'on dispose d'un temps plus important pour lire chaque ligne de détecteurs, on peut utiliser des amplificateurs ayant une bande passante moins élevée, ce qui entraîne une diminution du bruit. Enfin, le multiplexage peut, comme l'adressage, s'effectuer à fréquence plus basse et le choix des composants pouvant réaliser ce multiplexage est plus large.

Dans un second mode de lecture, on réduit le temps de lecture de la totalité du panneau. On conserve donc le même temps de lecture de chaque ligne de détecteurs que dans les panneaux selon l'art antérieur. On réduit ainsi la contribution du courant d'obscurité et on augmente le nombre d'images obtenues par seconde.

Comme le nombre d'éléments photosensibles reliés à chaque connexion de colonne est diminué, le signal parasite introduit par le courant d'obscurité et le bruit qui lui est associé sont réduits d'autant.

Enfin, le rendement de fabrication est augmenté du fait de la faible surface des modules à réaliser.

L'invention présente encore les avantages suivants. Il est plus facile de tester des modules de faibles dimensions qu'un seul panneau de grandes dimensions. Les modules sont interchangeables et il est possible d'en assembler un nombre quelconque selon les besoins. Le bruit introduit par les moyens d'adressage des connexions de ligne est aussi diminué puisque ces moyens d'adressage n'adressent qu'un petit nombre de connexions de ligne.

D'autres objets, caractéristiques et résultats de l'invention ressortiront de la description suivante, donnée à titre d'exemple non limitatif et illustrée par les figures annexées qui représentent :

- la figure 1 et la figure 2, une représentation schématique d'un panneau de prise de vue radiologique, respectivement, selon l'art antérieur et selon l'invention ;

- la figure 3, une vue en coupe d'un module du panneau de la figure 2 ;

- la figure 4, une représentation schématique d'un panneau de prise de vue radiologique décrit dans la demande de brevet français no 86.00716 ;

- la figure 5, un schéma de détail d'un détecteur photosensible du panneau de la figure 4 et des moyens de lecture associés ;

- les figures 6a à 6h, des signaux explicatifs du fonctionnement du panneau de la figure 4 et une première variante du procédé de lecture de ce panneau ;

- les figures 7a et b et 8a et b, des vues en coupe selon une colonne et une ligne de deux modes de réalisation du panneau de la figure 4 ;

- les figures 9a à 9h, et 10a à 10 h, des signaux explicatifs du fonctionnement du panneau de la figure 4 avec une seconde et une troisième variantes du procédé de lecture de ce panneau ;

- la figure 11, une vue en perspective éclatée montrant la réalisation sous forme intégrée d'un module selon l'invention ;

- la figure 12 une vue en coupe d'un panneau constitué de modules tel que celui de la figure 11 ;

- la figure 13, un mode de réalisation particulier d'un module selon l'invention ;

- la figure 14, une vue en perspective du substrat isolant 5 portant les connexions de colonne reliées aux moyens de lecture ;

- la figure 15, une vue en coupe du substrat isolant 5 illustrant une étape du procédé permettant d'établir des connexions entre les connexions de colonne et les moyens de lecture.

Sur les différentes figures, les mêmes repères désignent les mêmes éléments, mais, pour des raisons de clarté, les cotes et proportions des divers éléments ne sont pas respectées.

La figure 1 a été décrite dans l'introduction à la description.

La figure 2 montre les modifications apportées au panneau de prise de vue radiologique selon l'art antérieur de la figure 1. Le panneau selon l'invention est constitué de plusieurs modules indépendants, portant la référence 4, qui sont mis bout à bout. Chaque module comporte un réseau d'éléments photosensibles, disposés selon des lignes et des colonnes, avec des connexions de ligne et des connexions de colonne qui relient les détecteurs entre eux comme dans l'art antérieur. Le nombre de colonnes de détecteurs et de connexions de colonnes $C_1$ à $C_n$ n'est pas modifié. Par contre, le nombre de lignes de détecteurs et de connexions de lignes est diminué. Chaque module 4 comporte m lignes de détecteurs et m connexions de ligne, avec m inférieur à p.

La figure 3 est une vue en coupe de la figure 2 qui montre que les détecteurs d, dont une ligne est représentée, sont disposés sur un substrat isolant 5, en verre par exemple.

Chaque module a ses propres moyens d'adressage 2 reliés à ses connexions de ligne. On voit sur les figures 2 et 3 que les moyens d'adressage sont situés sur la face supérieure du substrat 5, côté détecteurs et sur un bord du substrat. Les moyens d'adressage sont situés sur un bord du substrat car on adresse les détecteurs ligne par ligne. Sur les figures 2 et 3, on a choisi de disposer les moyens d'adressage, sur chaque module 4, à droite du réseau de détecteurs. Un écran opaque au rayonnement à détecter, et non représenté, protège les moyens d'adressage.

Chaque module comporte aussi ses propres moyens de lecture 3. Sur la figure 3, on voit que ces moyens 3 sont portés par la face inférieure du substrat, c'est-à-dire qu'ils sont situés du côté du substrat 5 qui ne porte pas les détecteurs. Un écran 6, opaque au rayonnement à détecter est intercalé entre le substrat isolant 5 et les moyens de lecture. Des connexions relient les connexions de colonne situées sur la face supérieure du substrat aux moyens de lecture 3. Ces connexions ne sont pas représentées sur les figures 2 et 3. Ces connexions suivent l'une des faces latérales du substrat de façon à minimiser l'intervalle "i" qu'il faut ménager entre deux modules voisins. On tolère généralement un intervalle inférieur ou égal au pas des lignes de détecteurs.

Un panneau de prise de vue radiologique selon l'invention comporte donc un nombre de sorties égal au nombre de modules qui le constituent. On peut relier ces sorties à un multiplexeur parallèle/série.

Le rayonnement à détecter est généralement constitué par des rayons X. Il peut s'agir aussi par exemple de rayons de neutrons. Dans tous les cas de rayonnement utilisés en radiologie, on utilise un scintillateur placé devant le réseau de détecteurs qui transforme ce rayonnement en rayonnement visible auquel ces détecteurs sont sensibles. Le scintillateur n'absorbe pas complètement le rayonnement à détecter. C'est pourquoi un écran opaque à ce rayonnement est intercalé entre le substrat et les moyens de lecture. De même, les moyens d'adressage sont protégés par un écran opaque au rayonnement.

Les détecteurs, de par leur constitution, sont moins sensibles au rayonnement à détecter que les moyens d'adressage et de lecture. On s'efforce de constituer des réseaux de détecteurs comportant seulement des diodes et des capacités, et pas d'éléments de commutation, tels que des transistors qui sont plus sensibles aux rayons X.

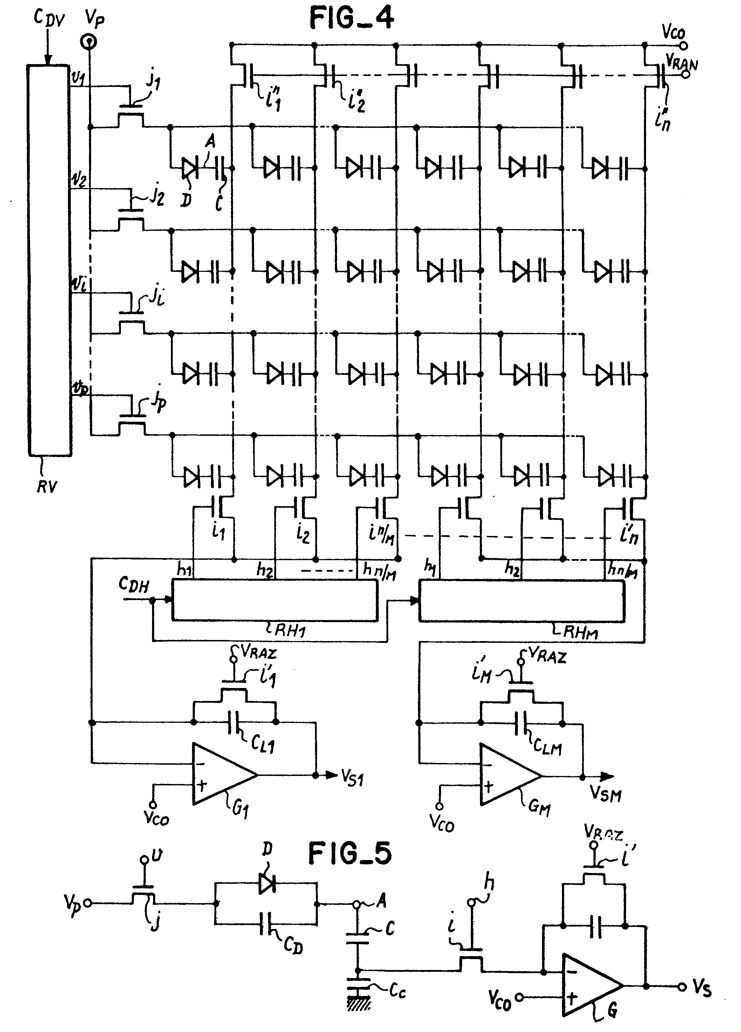

On va maintenant reprendre dans ce qui suit une partie du contenu de la demande de brevet français no 86.00716 en se référant aux figures 4 à 10 provenant de cette demande de brevet. On montrera ensuite quelles modifications apporte l'invention, objet de la présente demande de brevet, aux dispositifs décrits dans la demande de brevet français no 86.00716.

Sur la figure 4 qui représente une vue d'ensemble d'une matrice photosensible, un nombre n.p éléments photosensibles, chacun constitué d'une photodiode D en série avec une capacité C, sont arrangés suivant les lignes et les colonnes d'une matrice de p lignes et n colonnes, les diodes d'une même ligne sont reliées entre elles par une connexion de ligne, tandis que les capacités C d'une même colonne sont reliées entre elles par une connexion de colonne. Les connexions de lignes sont reliées à une tension d'adressage $V_P$ par l'intermédiaire de transistors MOS interrupteurs, $j_1$, $j_2...j_p$ commandés par les sorties $v_1$, $v_2...v_p$ d'un registre à décalage dit registre à décalage vertical, RV. Ce registre est commandé par un signal de commande $C_{DV}$ de décalage vertical. Ainsi, lorsqu'une ligne est sélectionnée pour être lue, toutes les diodes de cette ligne sont portées au niveau haut $V_{P1}$ du potentiel d'adressage $V_P$. De la même manière, les capacités d'une même colonne sont reliées aux entrées d'amplificateurs opérationnels montés en intégrateurs, par l'intermédiaire de transistors MOS interrupteurs $i_1$, $i_2...$, $i_n$ commandés par les sorties des étages de registres à décalage horizontaux.

On réalise un multiplexage des colonnes de la matrice, pour ne pas utiliser un amplificateur intégrateur par colonne : plusieurs colonnes successives sont reliées à l'entrée d'un même amplificateur opérationnel intégrateur. Les moyens de lecture comportent donc M amplificateurs, M étant un diviseur de n, et M registres à décalage horizontaux, chaque amplificateur et le registre à décalage horizontal associé étant utilisés pour la lecture de $\frac{n}{M}$ colonnes. Ainsi, les $\frac{n}{M}$ premières colonnes sont reliées aux sorties d'un registre à décalage horizontal $RH_1$, à $\frac{n}{M}$ étages, les connexions de colonnes correspondantes étant reliées à l'entrée "-" d'un amplificateur opérationnel $G_1$ monté en intégrateur : sa sortie est reliée à son entrée "-" par l'intermédiaire d'un condensateur de lecture $C_{L1}$. L'entrée "+" de cet intégrateur est reliée à un point de potentiel de référence colonne $V_{CO}$.

Cette structure est répétée pour chaque paquet de $\frac{n}{M}$ colonnes, le dernier amplificateur $G_M$ reliant les $\frac{n}{M}$ dernières colonnes. Les condensateurs d'intégration $C_L$ sont remis à zéro par des interrupteurs $i'_1...i'_M$ commandés par des impulsions de remise à zéro, $V_{RAZ}$. Enfin, toutes les colonnes peuvent être ensembles initialisées au potentiel de référence colonne $V_{CO}$ par une ligne de transistors MOS, $i''_1$, $i''_2...i''_n$ commandés par des impulsions de remise à niveau $V_{RAN}$. Les registres à décalage horizontaux sont commandés simultanément, par un signal de commande de décalage horizontal $C_{DH}$ appliqué à leurs entrées de commande, leurs sorties de même rang étant synchrones et délivrant les signaux, $h_1$, $h_2,..., h_{n/M}$. Les tensions de sortie des amplificateurs opérationnels intégrateurs sont $V_{S1}...V_{SM}$.

La figure 5 représente en détails le schéma équivalent d'un élément photosensible à photodiode D et capacité C, avec les différentes commandes d'adressage et l'amplificateur de sortie correspondant. Lorsque cet élément photosensible est sélectionné par le registre vertical $R_V$ de la figure 1, l'interrupteur j correspondant est fermé par la commande v et le potentiel $V_P$ est appliqué sur la diode D. La capacité $C_D$ de la diode a été représentée en parallèle sur cette diode D. Le point commun à la diode D et la capacité C a été désigné par A, l'autre extrémité de la capacité C étant reliée à l'entrée "-" de l'amplificateur opérationnel intégrateur G par l'intermédiaire du transistor MOS interrupteur i commandé par la sortie h d'un registre à décalage horizontal de sélection de la colonne.

Entre cette même borne de C et la masse a été représentée la capacité de la connexion de colonnes $C_c$.

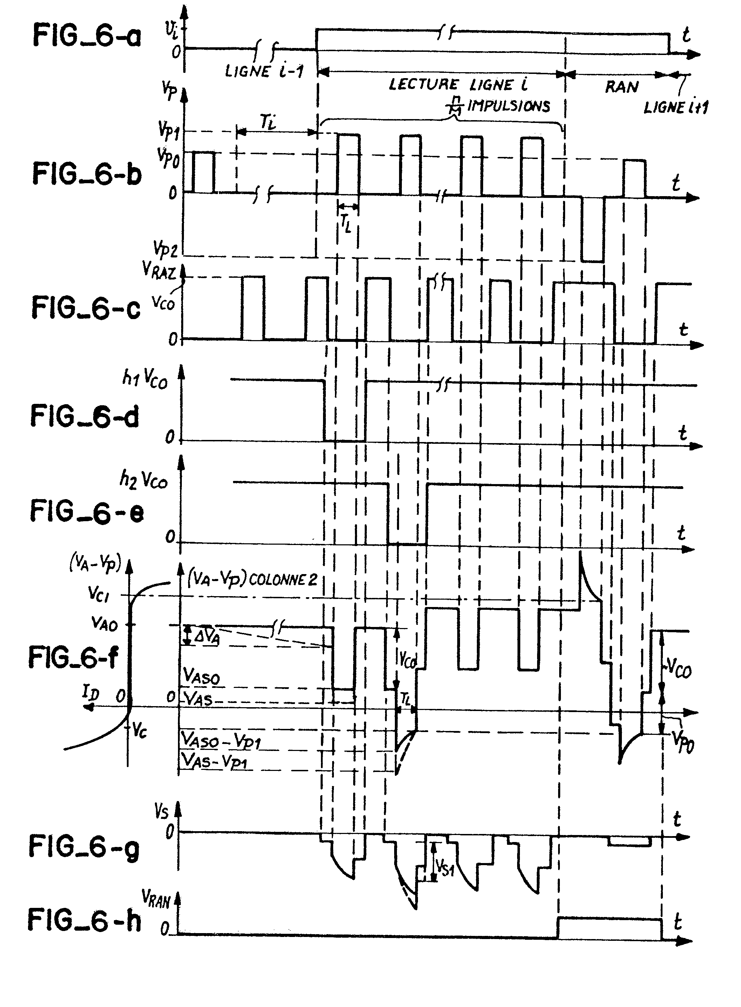

Les diagrammes des figures 6a à 6h représentent les différents signaux appliqués ou obtenus lors de la lecture d'un élément photosensible.

La demande de brevet français n° 86.00716 n'est pas limitée au cas de la radiologie et la description qui suit des figures 6a à h, 9a à h et 10a à h, doit être adaptée au cas de la radiologie où on ne lit pas le panneau quand on l'expose au rayonnement et où la remise à niveau est effectuée pour tout le panneau en même temps, avant l'exposition.

Si l'on considère les opérations de lecture de la $i^{ème}$ ligne, toutes les diodes de cette ligne ont été polarisées en inverse par la précédente lecture de cette même ligne, une durée $T_i$ auparavant, cette durée étant au minimum la durée nécessaire pour la lecture de toutes les autres lignes. Les points A communs entre diode D et capacité C des éléments photosensibles de cette ligne sont alors polarisés positivement, et laissés flottants pendant toute la durée $T_i$, cette durée étant également mise à profit pour l'intégration de l'information lumineuse à enregistrer par cette ligne. Le photocourant propre à chaque diode abaisse plus ou moins le potentiel de chaque point A par la décharge de chaque couple capacitif formé par la capacité C et la capacité de la diode $C_D$, comme le montre la figure 6f représentant la tension aux bornes d'une diode, où les traits pleins et pointillés représentent respectivement le cas où il n'y a pas de signal lumineux utile et le cas où il y a un signal lumineux utile. $C_D$ est supposée petite devant C, c'est-à-dire $C_D$ est inférieure ou égale à $\frac{C}{10}$.

Les opérations de lecture de la ligne se décomposent en deux séquences successives :

- tout d'abord la lecture séquentielle des informations stockées sur les points A des différents groupes de $\frac{n}{M}$ éléments photosensibles, les M groupes de colonnes étant lus simultanément grâce aux M registres à décalages horizontaux et aux M amplificateurs intégrateurs ;

- dans une seconde phase, la restauration simultanée du potentiel initial $V_{A0}$ des points A de toute la ligne, par une remise à niveau, soit au moyen d'une impulsion de polarisation négative appliquée à cette ligne suivie d'une lecture à blanc, soit au moyen d'un éclairement uniforme calibré appliqué sélectivement à la ligne de photodétecteurs, soit au moyen d'un flash lumineux intense suivi d'une lecture à blanc.

Ces deux opérations s'effectuent grâce à l'aiguillage de la tension d'adressage $V_P$ sur la $i^{ème}$ ligne par le registre à décalage vertical $R_V$ qui commande la fermeture de l'interrupteur $j_i$ correspondant à cette ligne : la tension appliquée à la ligne, $V_p$ est nulle pendant toute la durée $T_i$ et égale au niveau haut de $V_P$, $V_{P1}$ pendant la durée des impulsions de lecture $T_L$ comme le montre la figure 6b. La première séquence est une suite de impulsions de lecture, synchrones des impulsions de remise à zéro $V_{RAZ}$ court circuitant les condensateurs de lecture $C_L$ et des impulsions d'adressage $V_{CO}.h$ appliquées aux entrées positives des M amplificateurs, comme représenté sur les figures 6c où a été représenté $V_{CO}$ et $V_{RAZ}$, 6d et 6e où ont été représentés les produits logigues $V_{CO}.h_1$ et $V_{CO}.h_2$, correspondant à l'adressage des deux premières colonnes de chaque groupe. Ces impulsions d'adressage colonne, $V_{CO}.h$ résultent de la combinaison logique d'impulsions h commandant les interrupteurs i et d'impulsions appliquées au point de potentiel de référence des colonnes $V_{CO}$. Les impulsions h encadrent les impulsions $V_{CO}$ de façon que, à la fin d'une durée de lecture $T_L$, la tension de colonne soit bien ramenée au niveau haut de $V_{CO}$ avant la remise à niveau. Les impulsions d'adressage colonne et de remise à zéro débordent de chaque côté des impulsions de lecture $V_P$ : les impulsions $V_P$ passent au niveau haut $V_{P1}$ après que les impulsions $V_{CO}$ soient passées au niveau bas. Les impulsions de lecture ne sont donc transmises que sur les colonnes sélectionnées par les registres à décalage horizontaux, les autres colonnes restent chargées, au niveau haut de $V_{CO}$.

La figure 6f décrit l'évolution du potentiel $V_A-V_P$ aux bornes des diodes des colonnes 2, $\frac{n}{M}+2$, $2\frac{n}{M}+2$... Pendant l'adressage des colonnes précédentes 1, $\frac{n}{M}+1$, $2\frac{n}{M}+1$..., les autres colonnes demeurant au niveau haut, l'impulsion sur $V_P$ doit être d'amplitude $V_{P1}$ insuffisante pour polariser leurs diodes en direct, en l'absence de rayonnement utile, $V_{AS0} \geqq 0$, et également en présence de rayonnement $V_{AS} \geqq 0$. C'est ce qui apparaît sur la figure 6f où a été représentée, en plus de la tension $V_A-V_P$ en fonction du temps, la caractéristique de la diode : $I_D$ courant dans la diode en fonction de $V_A-V_P$ tension à ses bornes. Comme indiqué ci-dessus, le tracé en trait plein représente le potentiel en l'absence d'éclairement, le tracé en pointillés représente le potentiel d'une diode ayant intégrée une information lumineuse $Q_S$ pendant la période d'intégration $T_i$. $V_A$ représente l'amplitude du signal stocké sur la capacité C, les charges $Q_S$ étant égales à $C.V_A$.

L'amplitude de la variation de la tension aux bornes de la diode lors du passage de $V_P$ au niveau haut $V_{P1}$ est voisine de la variation d'amplitude de $V_P$. La lecture des M colonnes suivantes, 2, $\frac{n}{M}+2$... s'effectue par la coïncidence d'une impulsion $V_P$ avec la tension d'adressage correspondante représentée par le produit logique $V_{CO}.h_2$ sur ces colonnes. Dans ce cas l'amplitude de la variation de la tension aux bornes de la diode doit être suffisante pour polariser la diode largement en direct, même en l'absence de signal lumineux utile, au niveau $V_{AS0} - V_{P1}$, et bien entendu en présence de signal $V_{AS} - V_{P1}$. Si cette condition est réalisée, la tension aux bornes de la diode évolue pendant le temps de lecture $T_L$ jusqu'à une valeur $V_C$ indépendante de la tension de polarisation initiale et donc du signal. Cette tension est la tension de coude de la diode D. Dans ce cas la charge signal se trouve intégralement transmise à la capacité $C_L$ de l'amplificateur intégrateur correspondant, quelle que soit son amplitude. Elle se trouve additionnée à une charge $Q_0$ qui est la charge lue en l'absence de signal. L'intégrateur $G_1$, $C_{L1}$ délivre alors en sortie une tension $V_{S1}$ en présence de signal lumineux sur la colonne 2 qui correspond à la charge utile $Q_S$ et à $Q_0$

$$: \frac{Q_S + Q_0}{C_L} .$$

Cette tension est disponible directement après le retour à zéro de la tension $V_P$ et peut alors être prélevée par un échantillonneur avant le retour à zéro par $V_{RAZ}$. Les signaux $V_{CO}$ et $V_{RAZ}$ sont en phase mais peuvent avoir des niveaux différents.

Lors du retour de $h_2.V_{CO}$ au niveau haut, la diode D se trouve plus fortement polarisée en inverse qu'initialement du fait de la lecture de la charge $Q_0 + Q_S$. Le potentiel du point A s'écrit en effet

$$V_A = V_{A0} + \frac{Q_0 + Q_S}{C + C_D} .$$

Pendant la lecture de toutes les autres colonnes, la diode reste polarisée en inverse sans être affectée par les variations de poten tiel de $V_P$.

Au terme des $\frac{n}{M}$ impulsions de $V_P$, la séquence de lecture des colonnes est achevée pour la ligne i. La phase de remise à niveau de tous les points flottants A des diodes de cette ligne est alors effectuée. Le but de cette remise à niveau est de restaurer sur les diodes un potentiel $V_{A0}$ tel que les impulsions de $V_P$ ne puisse les polariser en direct lors d'une lecture même pour un éclairement maximum, et en même temps que la somme des amplitudes de $V_P$ et de $V_{CO}$ les polarise fortement en direct même en l'absence de signal. Cette double condition permet de sélectionner la lecture de chaque diode par la coïncidence des impulsions de commande de ligne, par $V_P$, et des impulsions de commande de colonne par $V_{CO}$ selon la description ci-dessus.

Pour obtenir le potentiel $V_{A0}$ nécessaire, il faut tout d'abord décharger le couple de capacités C et $C_D$, que l'opération de lecture précédente a rechargé à une tension supérieure à $V_{A0}$ où la diode ne peut plus être lue convenablement. Plusieurs méthodes sont possibles pour effectuer cette décharge : soit l'utilisation de la conduction en inverse de la diode au delà d'un certain seuil, soit un éclairement intense ou uniforme selon les applications envisagées.

En utilisant le seuil de conduction en inverse de la diode, l'opération de remise à niveau illustrée par les diagrammes de signaux des figures 6a et suivantes consiste à appliquer une impulsion négative d'amplitude $V_{P2}$ par $V_P$ qui polarise la diode au delà de son seuil de conduction en inverse. Celle-ci se décharge jusqu'à la tension de coude inverse $V_{CI}$, indépendante de la tension initiale. Pendant cette opération ainsi que pendant la suivante, toutes les colonnes sont polarisées au niveau haut de $V_{CO}$ par l'intermédiaire des transistors interrupteurs MOS $i''_1...i''_n$ commandés pour la remise à niveau par $V_{RAN}$. Cette opération de polarisation au delà du seuil de conduction en inverse est suivie par une séquence de lecture "à blanc" au terme de laquelle le potentiel final $V_{A0}$ peut être ajusté au moyen d'une impulsion de lecture d'amplitude déterminée $V_{P0}$. Ainsi la charge de polarisation $Q_0$ est ajustée indépendamment de la valeur de tension de coude inverse de la diode, qui peut varier sensiblement d'un élement à l'autre, pour que $V_C + V_{P0} + V_{CO} = V_{A0}$. Au terme de cette séquence le potentiel flottant de toutes les diodes de la $i^{ème}$ ligne est restauré pour commencer une nouvelle intégration de l'information lumineuse.

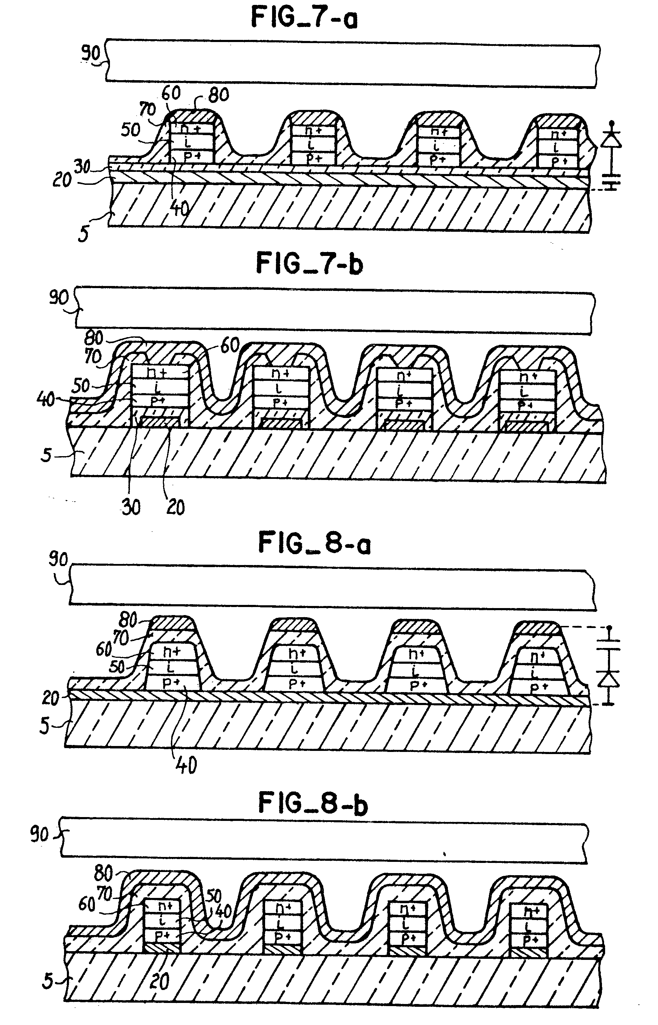

Une matrice d'éléments photosensibles, telle que décrite ci-dessus et représentée schématiquement sur la figure 4 peut être réalisée en suivant le procédé décrit ci-dessous en référence aux figures 7a et 7b pour une première variante, ou aux figures 8a et 8b pour une seconde variante. Les figures 7a et 8a représentent la matrice en coupe suivant une colonne, et les figures 7b et 8b représentent la matrice en coupe suivant une ligne respectivement pour les deux variantes du procédé.

Selon la première variante cette matrice est réalisée à partir de silicium amorphe de la manière suivante : une plaque de verre 1 formant le substrat est recouverte dans une première phase d'une couche de conducteur semi-transparent 20, par exemple du molybdène, du tantale ou de l'ITO (mélange d'oxyde d'indium et d'oxyde d'étain), qui est ensuite gravée pour former les conducteurs de colonnes. Une couche de matériau diélectrique 30 est alors formée, par exemple de l'oxyde de tantale $Ta_2 O_5$ de forte constante diélectrique sous une épaisseur de 0.2 µm obtenue par oxydation anodique de la couche précédente si celle-ci est réalisée en tantale, pour former les capacités C. Puis sont déposées sur cette couche les couches de silicium amorphe destinées à former les diodes PIN, D sous une épaisseur de l'ordre de 0.8 µm à 3 µm: par exemple une couche de silicium dopée p+, 40, une couche de silicium intrinsèque i, 50, et une couche de silicium dopée n+, 60. La gravure de ces couches superposées permet alors d'isoler les diodes superposées à la couche diélectrique formant les condensateurs et en contact avec le conducteur inférieur. Une couche de protection isolante 70, formée de nitrure ou d'oxyde de silicium par exemple, est alors déposée ; enfin des contacts sont ouverts dans la couche superficielle d'isolant 70 pour réaliser les conducteurs de ligne. Pour cela une couche de métal semi-transparent 80, ITO par exemple, est déposée ; cette couche est ensuite gravée pour former les conducteurs de ligne.

Un écran scintillateur 90 est déposé sur l'ensemble, l'image X étant projetée sur cette face de la matrice. Dans le cas où la remise à niveau est effectuée par éclairement comme il sera expliqué ci-après, les flash optiques de remise à niveau sont projetés du côté de la plaque de verre 1, le scintillateur étant opaque au rayonnement visible.

Selon la deuxième variante, illustrée par les figures 8a et 8b, où les mêmes couches que sur les figures 7a et 7b portent les mêmes références, les diodes sont réalisées avant les capacités, les capacités étant formées à partir de la couche d'isolant 70, ce qui évite l'ouverture de contacts dans cette couche, et évite le dépôt de la couche d'isolant 30. La couche 70 ne peut évidemment plus être réalisée par oxydation du conducteur semi-transparent inférieur (tantale). La succession des couches est alors la suivante : sur la plaque de verre 10 est déposé un matériau conducteur semi-transparent 20 qui est ensuite gravé, puis les couches de silicium 40 dopée p+, 50 intrinsèque, et 60 dopée n+. Après gravure pour isoler les diodes la couche de matériau diélectrique 70 est déposée et constitue les capacité C. La dernière couche 80 de conducteur semi-transparent est alors déposée puis gravée.

La structure ainsi obtenue pour la matrice et le procédé de lecture associé présentent plusieurs avantages dans le cas d'un photosenseur matriciel de grande dimension pour lequel on souhaite obtenir une résolution élevée :

- le bruit de lecture peut être réduit ;
- la fréquence de fonctionnement des registres à décalage horizontaux peut également être réduite par le facteur M du fait du multiplexage ;
- l'élément photosensible qui est une association capacité et diode a une structure très simple, résistante au rayonnement X, ce qui est un avantage capital pour un senseur destiné à l'imagerie par rayonnement X, employé avec un scintillateur.

En ce qui concerne la fréquence de fonctionnement des registres à décalage horizontaux, du fait de sa réduction, les registres peuvent être réalisés avec des transistors de mobilité réduite, comme c'est le cas pour une matrice photosensible utilisant un matériau du type silicium amorphe. Ce matériau est alors utilisé pour l'ensemble de la structure ce qui simplifie considérablement les problèmes de connexion.

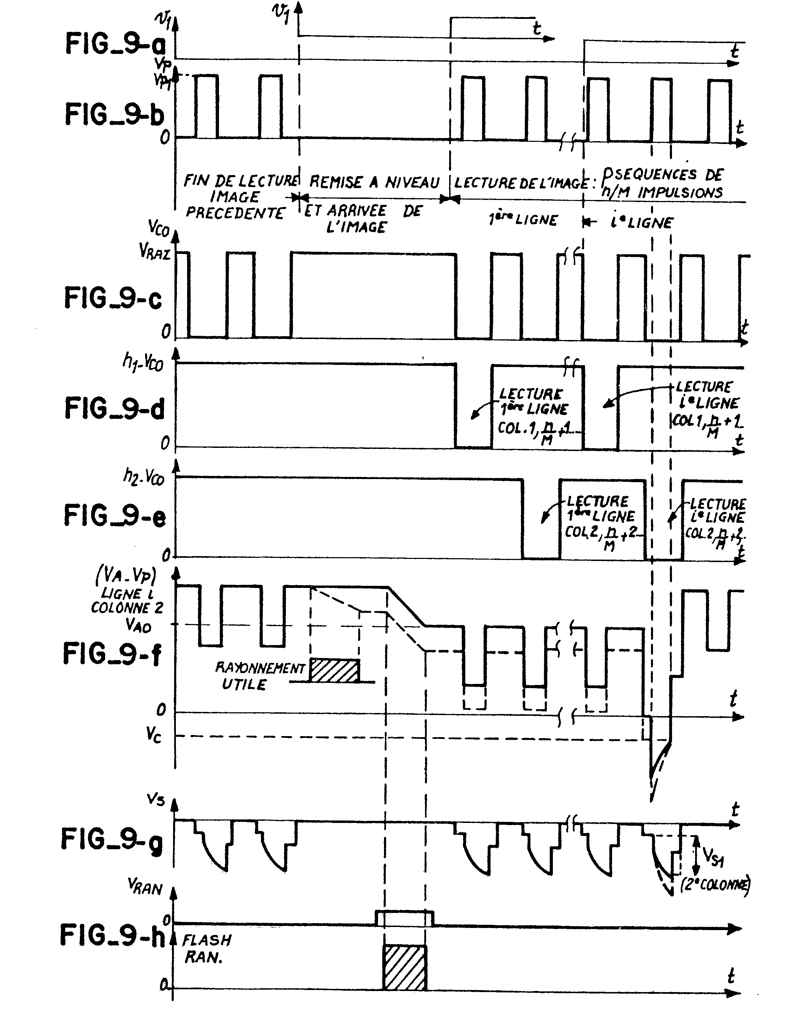

Il a été indiqué ci-dessus que l'opération de remise à niveau indispensable pour que la lecture puisse être répétée, pouvait être effectuée en éclairant uniformément les diodes de façon à les décharger, cet éclairement ayant une intensité et une durée prédéterminées. Les signaux explicatifs de la variante du procédé de lecture mettant en oeuvre une telle remise à niveau sont représentés sur les figures 9 dans le cas d'une application où la remise à niveau est effectuée en une seule fois pour toute la matrice. Les lettres références des figures 9 et suivantes sont identiques à celles des figures 6 et suivantes pour les mêmes signaux. La structure des impulsions $V_P$ est modifiée comme représenté sur la courbe de la figure 9b : l'impulsion négative nécessaire à la décharge pour une remise à niveau électrique est supprimée ; elle est remplacée par l'éclairement calibré représenté sur la figure 9h qui décharge pendant un temps prédéterminé toutes les diodes de la matrice après la lecture de toutes les lignes de l'image précédente. C'est cette décharge qui fixe la tension de départ $V_{AO}$ ; l'impulsion de lecture à blanc d'amplitude $V_{PO}$ est également supprimée. Les impulsions de lecture suivantes réalisent les lectures successives des diodes de la matrice, en coïncidence avec les impulsions $V_{CO}$ commandées par les registres horizontaux. Chaque diode qui vient d'être lue doit se trouver suffisamment polarisée en inverse pour ne plus être affectée par les autres impulsions de la séquence. Pour que les diodes de cette même ligne ne puissent être lues par les coïncidences $V_P$ et $V_{CO}$ destinées à la lecture des lignes suivantes, il importe de choisir le fond de charge de polarisation $Q_0$ supérieur à la charge signal maximal $Q_S$ (max) pour que le potentiel des points A, après lecture, $(V_A-V_P)_{TL}$ soit toujours supérieur à $V_{AO}$. Ce n'est qu'après une nouvelle remise à niveau que la décharge conduit au potentiel des points flottants $V_{AO}$ convenable pour la lecture. Dans cette variante, contrairement aux autres, l'exposition au rayonnement utile peut avoir lieu après la remise à niveau, comme précédemment, mais peut également se faire avant la remise à niveau, ou même en même temps ; ce qui peut être le cas pour une arrivée permanente d'image, dans le cas d'un imageur visible. L'intégration sur chaque ligne a alors lieu pendant la lecture de toutes les autres lignes, mais entre chaque lecture de toute la matrice doit avoir lieu la séquence de remise à niveau.

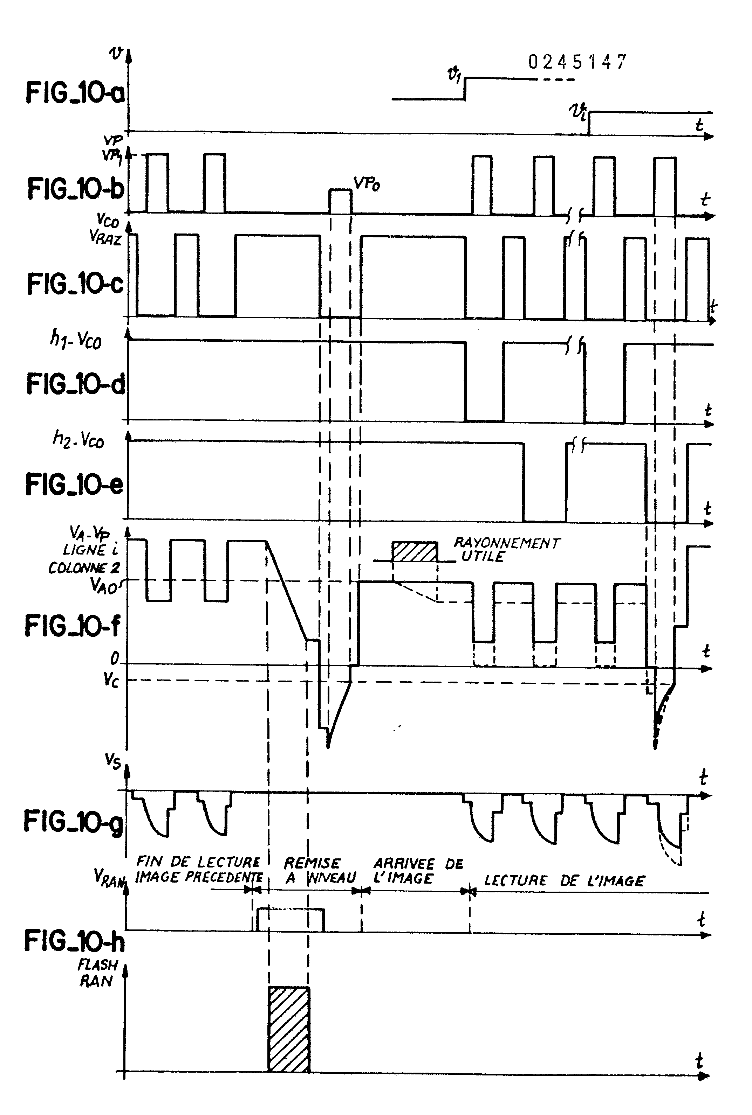

La remise à niveau peut également être obtenue au moyen d'un éclairement intense. Les signaux explicatifs de la variante du procédé de lecture mettant en oeuvre une telle remise à niveau sont représentés sur les figures 10a à 10h également dans le cas d'une application où la remise à niveau est effectuée pour tout le panneau en une seule fois. L'éclairement intense, non calibré, illustré par la figure 8h décharge la capacité C beaucoup plus qu'il ne serait nécessaire pour revenir à la tension de départ $V_{AO}$. Puis, une lecture à blanc est effectuée au moyen d'une impulsion de lecture supplémentaire représentée sur la figure 10b, de niveau calibré $V_{PO}$, inférieur à $V_{P1}$, semblable à celle introduite après une polarisation fortement inverse comme sur la figure 6b. Ainsi la tension au point A des diodes de la ligne à lire est ramenée à la tension de départ $V_{AO}$ nécessaire, sans que l'éclairement soit calibré. On introduit alors une charge de polarisation $Q_0 = C(V_{P1}-V_{PO})$. Du fait qu'une lecture à blanc est effectuée pour amener la tension à $V_{AO}$, l'intégration de l'information utile ne peut avoir lieu qu'après la séquence de remise à niveau de l'ensemble du panneau.

Dans la prise de vue d'images radiologiques il n'y a qu'une seule exposition et une seule lecture de la matrice. L'opération de remise à niveau est effectuée pour l'ensemble de la matrice, préalablement à une exposition comme indiqué ci-dessus. La lecture peut alors être effectuée ligne par ligne par un adressage électronique.

Selon la présente invention, le panneau de prise de vue radiologique, décrit dans la demande de brevet français n° 86.00716, et illustré dans sa structure, son fonctionnement et sa réalisation par les figures 4 à 10, est constitué par plusieurs modules 4 mis bout à bout comme cela a été expliqué en se référant aux figures 2 et 3.

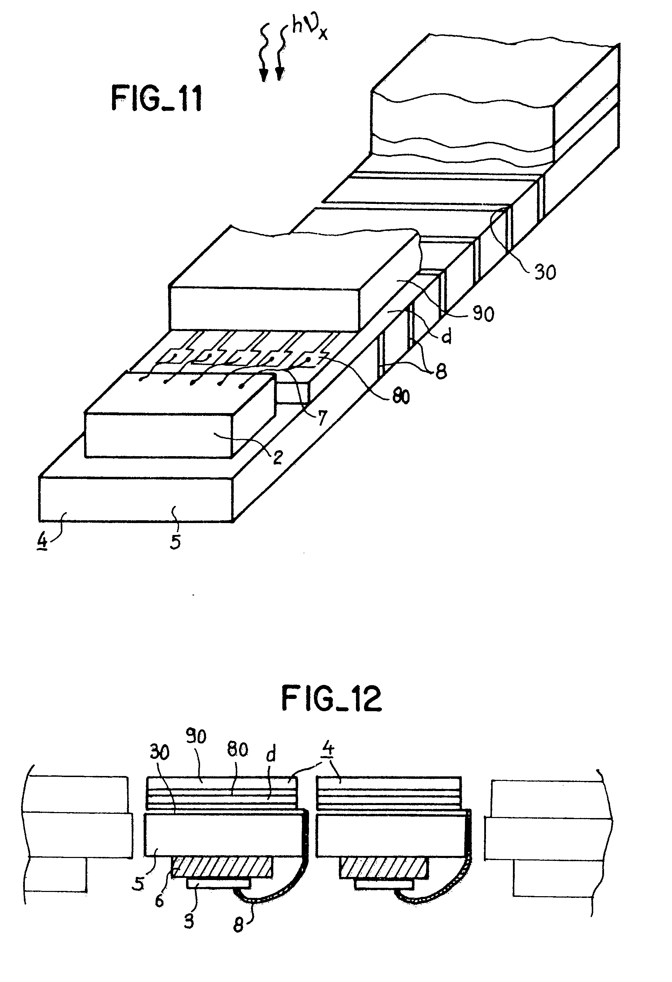

Sur la figure 11, on a représenté l'un de ces modules 4 en perspective éclatée.

Il est clair que les procédés de fabrication exposés en se référant aux figures 7a et b et 8a et b peuvent être utilisés pour réaliser ces modules. Les signes de référence utilisés sur les figures 7a et b, et 8a et b vont être à dessein utilisés sur la figure 11.

Le module 4 de la figure 11 comporte de haut en bas :

- un écran scintillateur 90 ;
- des connexions de ligne 80 ;
- des détecteurs d, qui peuvent indifféremment comporter une diode puis une capacité comme sur la ligne 7a, ou une capacité puis une diode comme sur la figure 8a ;
- des connexions de colonne 30 ;
- un substrat isolant en verre 5.

Comme cela a été expliqué en se référant aux figures 2 et 3, chaque module 4 comporte ses propres moyens d'adressage 2 situés sur la face supérieure du support isolant 10, côté détecteurs. Des fils de connexion 7, soudés, relient les connexions de ligne 80 aux moyens d'adressage 2, qui peuvent être constitués comme dans l'exemple de la figure 4 par un registre à décalage et des transistors MOS.

La figure 12 est une vue en coupe d'un panneau selon l'invention constitué par des modules 4 tel que celui de la figure 11.

Comme cela a été expliqué dans la description des figures 2 et 3, chaque module comporte ses propres moyens de lecture 3, qui peuvent être constitués comme dans l'exemple de la figure 4 par un registre à décalage, un amplificateur opérationnel monté en intégrateur et des transistors MOS. Les moyens de lecture 3 sont portés par la face inférieure du substrat 10, dont ils sont séparés par un écran en plomb 6. Des connexions 8 qui suivent l'une des faces latérales du substrat 5 relient les connexions de colonne 30 aux moyens de lecture 3.

Sur la figure 12, on a représenté la partie de ces connexions 8 qui suit une face latérale du substrat 10. Cette partie des connexions 8 peut être constituée par une métallisation portée par la face latérale du substrat. L'autre partie de ces connexions qui rejoint les moyens de lecture peut être constituée par des connexions souples soudées.

On a vu dans la description des figures 4 à 10 qu'il faut dans le cas de la radiologie éclairer tous les détecteurs du panneau pour effectuer une remise à niveau avant une nouvelle inscription de l'information utile.

Cet éclairement ne peut s'effectuer du côté du scintillateur qui en général est opaque.

L'invention propose une structure adaptée à cette nécessité d'éclairer le panneau.

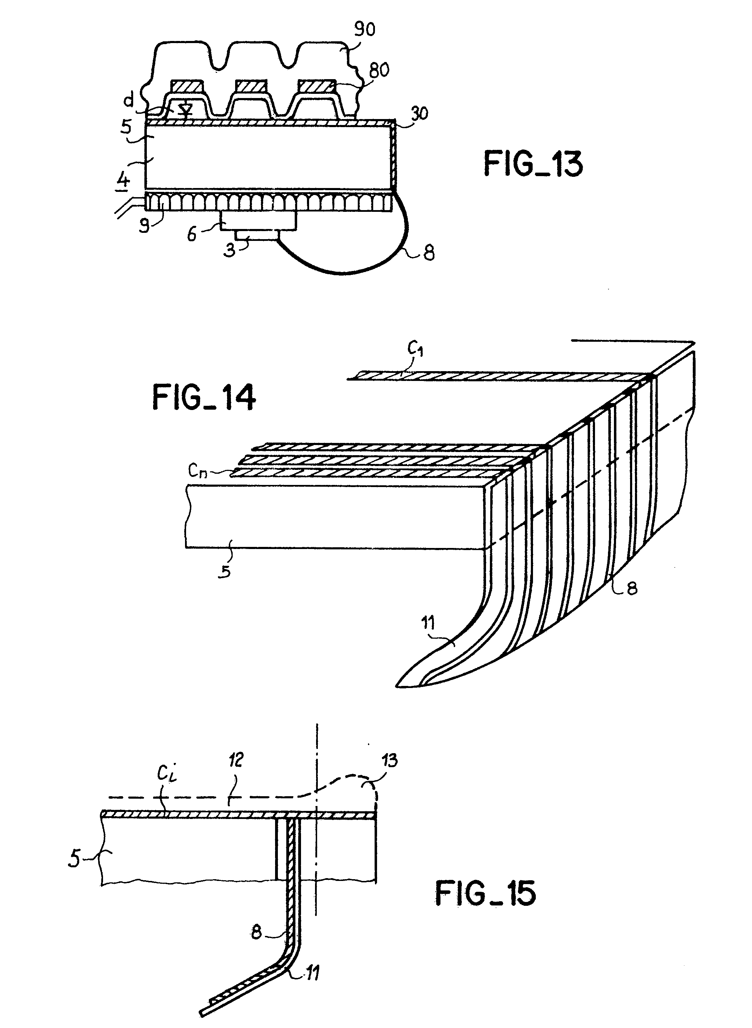

La figure 13 représente une vue en coupe d'un module 4. Sur cette figure, on a représenté de façon un peu plus détaillée que sur la figure 12, les formes du scintillateur 90, des connexions de ligne 80, et des détecteurs d.

La seule différence entre le module de la figure 13 et ceux de la figure 12 réside en la présence d'un panneau générateur de lumière 9 qui est intercalé entre la face inférieure du substrat 10 et l'écran 6 qui porte les moyens de lecture 3. Ce panneau générateur de lumière 9 peut être constitué par un réseau de diodes électroluminescentes. Le substrat isolant 5 doit alors être transparent. Un substrat en verre convient parfaitement. En ce qui concerne les connexions de colonnes 30, dans les procédés de fabrication illustrés par les figures 7a et b, et 8a et b, il est dit que ces connexions peuvent être formées de conducteur semi-transparent, par exemple du molybdène, du tantale ou de l'ITO (mélange d'oxyde d'indium et d'oxyde d'étain). Les connexions de colonne 30, dans la mesure où elles sont semi-transparentes, permettent donc d'éclairer les détec teurs grâce au panneau 9.

Les figures 11, 12 et 13 ont été décrites dans le cadre du panneau de prise de vue radiologique qui a fait l'objet de la demande de brevet français no 86.00716. Il est clair que des panneaux de prise de vue radiologique différents, par leurs détecteurs, leurs moyens d'adressage ou/et de lecture peuvent être également réalisés comme sur les figures 2, 3, 11, 12 et 13 par des modules, réalisés de part et d'autre d'un substrat isolant.

Dans la description des figures 2 et 3, on a expliqué que les connexions reliant ces connexions de colonne $C_1$ à $C_n$ aux moyens de lecture 3 situés sur la face opposée du substrat isolant 5 suivaient l'une des faces latérales du substrat 1 de façon à minimiser l'intervalle i qu'il faut ménager entre deux modules voisins. Cet intervalle doit être inférieur à 200 micromètres dans un exemple de réalisation. Il faut que ce passage des connexions d'une face du subtrat à la face opposée soit compatible avec le raboutage des modules entre eux. La technologie utilisée doit être compatible avec les autres étapes de fabrication des modules : par exemple, le dépôt de silicium amorphe, la gravure... Enfin, cette technologie doit être suffisamment fiable pour assurer les très nombreuses connexions reliant les connexions de colonne aux moyens de lecture, de l'ordre de 2000 connexions par exemple pour un panneau.

Un grand nombre de technologies peuvent être utilisées pour réaliser ces connexions. Dans la description de la figure 12, on a dit que ces connexions pouvaient par exemple être constituées par une métallisation portée par la face latérale du substrat puis par des connexions souples soudées reliées aux moyens de lecture.

Un autre objet de la présente invention est un procédé de fabrication des connexions de colonne et de leurs connexions avec les moyens de lecture qui va être décrit en se référant aux figures 14 et 15.

Sur la figure 14, on a représenté le substrat isolant 5 qui va servir de support au module.

On colle sur l'une des faces latérales de ce substrat isolant 5 un support isolant souple 11 portant des conducteurs 8. L'isolant utilisé peut être du polyimide, du "Kapton" par exemple, portant des conducteurs souples en cuivre.

On rode ce support isolant 11 pour que les extrémités des conducteurs 8 soient situées dans le même plan que la face supérieure du substrat isolant 5, destinée à porter les détecteurs. Le rodage peut s'effectuer par polissage par exemple.

On dépose ensuite sur la face supérieure du substrat 5 les connexions de colonnes $C_1$ à $C_n$ de telle sorte qu'à l'extrémité du substrat ces connexions $C_1$ à $C_n$ chevauchent les connexions 8 potées par le support isolant souple 11.

Les connexions de colonne $C_1$ à $C_n$ peuvent par

exemple être réalisées de la façon suivante. On effectue un dépôt métallique sur la face supérieure du substrat 5 par évaporation sous vide par exemple. On recouvre le dépôt métallique par de la résine photosensible, puis, on réalise une photogravure en utilisant un masque, indexé sur les conducteurs portés par le support isolant souple 11 pour qu'à l'extrémité du substrat les connexions de colonne chevauchent les conducteurs portés par le support isolant souple de façon à assurer le contact électrique.

On réalise alors les diverses étapes nécessaires à la fabrication du module, telles par exemple qu'elles ont été décrites en liaison avec les figures 7a et b, et 8a et b. Lors de ces étapes, la température ne doit pas dépasser environ 250°C, dans le cas où l'on utilise un support isolant souple en polyimide. On relie les conducteurs 8 portés par le support isolant souple 11 aux moyens de lecture par des micro-soudures.

Lors de la mise en oeuvre du procédé qui vient d'être exposé, on rencontre un problème dû à la forme généralement rectangulaire du substrat isolant 5 destiné à constituer un module comportant généralement plus de colonnes que de lignes d'un panneau de prise de vue radiologique selon l'invention.

Ce problème se pose lors du dépôt de la résine photosensible utilisée pour réaliser par photogravure les connexions de colonne $C_1$ à $C_n$ sur la face supérieure du substrat 5.

Lorsqu'on dispose d'un substrat de forme carrée, on le place sans difficulté sur un appareil qui provoque sa rotation. Le substrat tourne à grande vitesse et l'on dépose sur sa face supérieure de la résine photosensible qui s'étale selon un film d'épaisseur constante.

Dans le cas d'un substrat de forme carrée, on rencontre des difficultés car la rotation n'est pas parfaite et l'on constate que la résine ne s'étale pas convenablement.

On dépose alors la résine par trempage et retrait du substrat 5.

L'inconvénient de ce type de dépôt est qu'il entraîne une surépaisseur de résine à la périphérie du substrat. Cette surépaisseur altère la résolution lors de la photogravure, c'est à dire que le temps d'insolation doit être plus élevé à la périphérie du substrat qu'en son centre.

Pour résoudre ce problème, on propose de modifier le procédé exposé en liaison avec la figure 14 de la façon suivante.

Comme cela est représenté sur la figure 15 qui est une vue en coupe montrant le substrat 5 et l'une des connexions $C_1$ à $C_n$, soit $C_i$, sur sa face supérieure, on colle toujours sur l'une des faces latérales du substrat 5 un support isolant souple 11 portant des conducteurs 8.

On prolonge ensuite sur une courte distance, par exemple de l'ordre de quelques millimètres, la face latérale du substrat 5 sur laquelle est collé le support isolant souple 11. Cette prolongation de la face latérale du substrat 5 peut être réalisée, par exemple, grâce à la résine époxy qui peut être utilisée pour coller le support isolant souple 11 sur le substrat.

On rode le support isolant souple 11 pour que les extrémités des conducteurs 8 soient situées dans le même plan que la face supérieure du substrat isolant 5, destinée à porter les détecteurs.

Pour réaliser les connexions de colonne, on dépose une couche métallique sur la face supérieure du substrat 5, par évaporation sous vide par exemple.

Ensuite, on effectue un dépôt de résine photosensible par trempage et retrait du substrat 5. Sur la figure 15, on a représenté en pointillés la couche de résine photosensible 12 ainsi obtenue qui présente une surépaisseur 13 à l'extrémité du substrat.

On réalise ensuite une photogravure en utilisant un masque indexé sur les conducteurs portés par le support isolant souple 11, comme précédemment.

On élimine ensuite l'effet de la surépaisseur de résine photosensible, en rodant une partie de la face latérale du substrat qui a été précédemment ajoutée.

On peut par exemple roder cette face latérale jusqu'au trait vertical constituée de points et de traits qui est indiqué sur la figure 15. En éloignant du bord - durant la fabrication - la zone de contact entre les connexions horizontales et verticales, on supprime les effets de bord qui peuvent dégrader la fiabilité de ces contact pendant les étapes de fabrication ultérieures. Les connexions portées par le support isolant souple sont reliées aux moyens de lecture par soudure soit avant, soit après les rodages de la face latérale.

Il est bien clair que l'invention peut s'appliquer aux panneaux de prise de vue radiologique, quels que soient les détecteurs utilisés dans ces panneaux. Ainsi, ces détecteurs ne sont pas nécessairement constitués par une photodiode en série avec une capacité, comme c'est le cas sur les figures 4 à 13.

On connait par exemple un panneau de prise de vue radiologique dans lequel chaque élément photosensible comporte une photodiode et une capacité en série avec un interrupteur, pouvant être constitué par exemple par un transistor MOS ou par deux diodes tête-bêche.

Quelles que soient les variantes que peuvent comporter les panneaux de prise de vue radiologique, aussi bien en ce qui concerne les détecteurs, que les moyens d'adressage et de lecture, l'invention peut s'appliquer. L'invention s'applique donc à tous les types de panneaux de prise de vue radiologique comportant un réseau de détecteurs, des connexions de lignes et de colonnes, un scintillateur, des moyens d'adressage, successivement, de chaque ligne de détecteurs et des moyens de lecture de la ligne de détecteurs adressée.

L'invention telle qu'elle est illustrée par les figures 2, 3, 11, 12 et 13 peut être appliquée à tous ces panneaux et le procédé de fabrication illustré par les figures 14 et 15 peut aussi être appliqué à tous ces panneaux.

**Revendications**

1. Panneau de prise de vue radiologique, comportant des détecteurs photosensibles (d), portés par un substrat isolant (5), disposés selon les lignes et des colonnes, reliés entre eux par des connexions de lignes et des connexions de colonnes, et qui reçoivent le rayonnement à détecter par l'intermédiaire d'un scintillateur (90), des moyens (2) reliées aux connexions de lignes, permettant l'adressage, successivement, de chaque ligne de détecteurs photosensibles et des moyens (3), reliées aux connexions de colonnes, permettant la lecture de la ligne de détecteurs photosensibles adressée, caractérisé en ce que ce panneau est constitué de plusieurs modules (4), mis bout à bout, chaque module comportant un réseau de détecteurs photosensibles ayant le même nombre de colonnes ($C_1$ à $C_n$) que le panneau, mais ayant un nombre inférieur de lignes ($L_1$ à $L_m$), et chaque module (4) ayant ses propres moyens d'adressage (2) et de lecture (3), les moyens d'adressage (2) étant situés sur un bord du substrat (5), côté détecteurs, et protégés du rayonnement à détecter par un écran, les moyens de lecture (3) étant situés de l'autre côté du substrat (5) par rapport aux détecteurs (d), un écran (6) opaque au rayonnement à détecter étant intercalé entre le substrat (5) et ces moyens (3), et ces moyens (3) étant reliés aux connexions de colonnes ($C_1$ à $C_n$) provenant du côté opposé du substrat (5) par des connexions (8) suivant l'une des faces latérales du substrat (5).

2. Panneau selon la revendication 1, caractérisé en ce que chaque module (4) est réalisé sur un substrat (5), dont l'une des faces comporte la superposition, des connexions de colonnes ($C_1$ à $C_n$), des détecteurs photosensibles (d), des connexions de ligne ($L_1$ à $L_m$), du scintillateur (90), les moyens d'adressage (2) étant disposés sur un bord du substrat (5), et l'autre côté du substrat comportant la superposition d'un écran (6) protégeant du rayonnement à détecter et des moyens de lecture (3).

3. Panneau selon l'une des revendications 1 ou 2, caractérisé en ce que le substrat (5) est transparent au rayonnement visible et en ce qu'un panneau (9) qui sur commande émet un rayonnement visible recouvre la face du substrat (5) qui porte un écran (6) opaque au rayonnement à détecter et les moyens de lecture (3).

4. Panneau selon la revendication 3, caractérisé en ce que le panneau (9) qui sur commande émet un rayonnement visible est un panneau de diodes électroluminescentes.

5. Panneau selon l'une des revendications 1 à 4, caractérisé en ce que les connexions de colonnes ($C_1$ à $C_n$) sont des connexions déposées sur une face du substrat isolant (5), côté détecteurs, puis sont des connexions (8) déposées sur un support isolant souple (11) qui est collé sur une face latérale du substrat isolant (5), ces connexions (8) étant soudées aux moyens de lecture (3).

6. Procédé de fabrication d'un panneau selon la revendications 5, caratérisé en ce que la réalisation des connexions de colonnes ($C_1$ à $C_n$) et de leurs connexions avec les moyens de lecture (3) comporte les étapes suivantes :
   - 1o) on colle sur l'une des faces latérales du substrat isolant (5) un support isolant souple (11) portant des conducteurs (8) ;
   - 2o) on rode ce support pour que les extrémités des connexions (8) qu'il porte soient situés dans le même plan que la face du substrat, côté détecteurs ;
   - 3o) on dépose sur la face du substrat, côté détecteurs, les connexions de colonnes ($C_1$ à $C_n$) de telle sorte qu'à l'extrémité du substrat (5) les connexions déposées chevauchent les connexions (8) portée par le support isolant souple (11);
   - 4o) on relie les connexions (8) portées par le support isolant souple (11) aux moyens de lecture (3) par soudure.

7. Procédé selon la revendication 6, caractérisé en ce que, lors de la troisième étape, le dépôt des connexions de colonnes ($C_1$ à $C_n$) est réalisé par évaporation sous vide, suivie par le dépôt d'une résine photosensible et par une photo-gravure avec masque.

8. Procédé selon la revendication 7, caractérisé en ce que le dépôt de la résine photosensible se fait par trempage du substrat isolant (5), puis retrait.

9. Procédé selon la revendication 8, caractérisé en ce qu'après la première étape, on prolonge sur une faible distance la face latérale du substrat isolant (5), on réalise la deuxième et la troisième étapes, puis l'on rode le substrat (5) de façon à éliminer sensiblement la partie qui lui a été adjointe.

10. Procédé selon l'une des revendications 6 à 9, caractérisé en ce que l'opération de rodage est effectuée par polissage.

## FIG_1

$c_1$    $d$    $c_n$

$L_1$

$1$

$L_p$

MOYENS DE LECTURE    →S

$2$

MOYENS D'ADRESSAGE

$3$

## FIG_2

$c_1$    $c_n$

$L_1$

$L_m$

$4$

$4$

$i$

$2$

## FIG_3

$d$

$2$

$5$

$6$

$3$

0245147

FIG_4

FIG_5

FIG_6-a

FIG_6-b

FIG_6-c

FIG_6-d

FIG_6-e

FIG_6-f

FIG_6-g

FIG_6-h

0245147

## FIG_7-a

## FIG_7-b

## FIG_8-a

## FIG_8-b

0245147

FIG_9-a

FIG_9-b

FIN DE LECTURE IMAGE PRECEDENTE — REMISE A NIVEAU ET ARRIVEE DE L'IMAGE — LECTURE DE L'IMAGE : p SEQUENCES DE h/M IMPULSIONS — 1ère LIGNE — i° LIGNE

FIG_9-c

FIG_9-d — LECTURE 1ère LIGNE COL.1, $\frac{n}{M}$ +1 — LECTURE i° LIGNE COL 1, $\frac{n}{M}$ +1

FIG_9-e — LECTURE 1ère LIGNE COL 2, $\frac{n}{M}$ +2 — LECTURE i° LIGNE COL 2, $\frac{n}{M}$ +2

FIG_9-f — RAYONNEMENT UTILE

FIG_9-g — $V_{S1}$ (2° COLONNE)

FIG_9-h — FLASH RAN.

FIG_10-a

FIG_10-b

FIG_10-c

FIG_10-d

FIG_10-e

FIG_10-f

FIG_10-g

FIG_10-h

RAYONNEMENT UTILE

FIN DE LECTURE IMAGE PRECEDENTE — REMISE A NIVEAU — ARRIVEE DE L'IMAGE — LECTURE DE L'IMAGE

FLASH RAN

$h\nu_x$

## FIG_11

30

90

d

8

80

7

2

4

5

## FIG_12

30 90 80 d 4

5

6

3

8

0245147

FIG_13

FIG_14

FIG_15

## Office européen des brevets

# RAPPORT DE RECHERCHE EUROPEENNE

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | DE-A-3 531 448 (KABUSHIKI KAISHA TOSHIBA) <br> * Abrégé; revendications; page 10, ligne 1 - page 13, ligne 22; figures 2-4 * | 1 | H 01 L 27/14 <br> G 01 T 1/00 |
| | --- | | |
| A | ELECTRONIQUE INDUSTRIELLE, no. 66, 1er mars 1984, pages 19-20, Paris, FR; H. ROUGEOT: "Les détecteurs X sensibles à l'état solide pour le contrôle non destructif" <br> * En entier * | 1 | |
| | --- | | |
| A | EP-A-0 153 251 (THOMSON-CSF) | | |
| | --- | | DOMAINES TECHNIQUES RECHERCHES (Int. Cl.4) |
| A | EP-A-0 125 691 (FUJI PHOTO FILM CO., LTD.) | | H 01 L <br> G 01 T <br> H 04 N |
| | --- | | |
| A | FR-A-2 335 056 (THOMSON-CSF) | | |
| | ----- | | |

Le présent rapport de recherche a été établi pour toutes les revendications

| Lieu de la recherche | Date d'achèvement de la recherche | Examinateur |
|---|---|---|
| LA HAYE | 18-06-1987 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82